(19)

Europäisches
Patentamt
European
Patent Office
Office européen
des brevets

(11)   **EP 2 392 457 A1**

(12)   # EUROPEAN PATENT APPLICATION
published in accordance with Art. 153(4) EPC

(43) Date of publication:
   **07.12.2011 Bulletin 2011/49**

(51) Int Cl.:
   ***B32B 27/20*** (2006.01)   ***H01L 31/042*** (2006.01)

(21) Application number: **10735914.3**

(22) Date of filing: **29.01.2010**

(86) International application number:
   **PCT/JP2010/051272**

(87) International publication number:
   **WO 2010/087452 (05.08.2010 Gazette 2010/31)**

(84) Designated Contracting States:
   **AT BE BG CH CY CZ DE DK EE ES FI FR GB GR HR HU IE IS IT LI LT LU LV MC MK MT NL NO PL PT RO SE SI SK SM TR**

(30) Priority: **30.01.2009 JP 2009019616**

(71) Applicant: **Techno Polymer Co., Ltd.**
   **Minato-ku**
   **Tokyo 105-0021 (JP)**

(72) Inventors:
   • **HASHIMOTO Masanori**
    **Tokyo 105-0021 (JP)**
   • **WATANABE Atsushi**
    **Tokyo 105-0021 (JP)**

(74) Representative: **Wilhelms · Kilian & Partner**
   **Patentanwälte**
   **Eduard-Schmid-Straße 2**
   **81541 München (DE)**

(54)   **MULTILAYER BODY**

(57)   The present invention provides a layered product which has excellent sunlight reflection performance, and can obtain high conversion efficiency when used as back sheets for solar cells, and also has excellent infrared light reflection performance, and low heat storage. The layered product comprises: a layer (A) comprising 0.1-40 parts by mass of titanium oxide particles per 100 parts by mass of a thermoplastic resin in which the titanium oxide particles have a volume average particle diameter of 0.01 $\mu$m - 0.35 $\mu$m and include particles having a particle diameter of 0.5 $\mu$m or more in an amount of less than 10 mass%; and a layer (B) comprising 0.1-40 parts by mass of titanium oxide particles per 100 parts by mass of a thermoplastic resin in which the titanium oxide particles have a volume average particle diameter of 0.5 $\mu$m - 2 $\mu$m and include particles having a particle diameter of 0.35 $\mu$m or less in an amount of less than 10 mass%. The titanium oxide is preferably of a rutile form. The thermoplastic resin of the layer (A) and/or layer (B) preferably comprises an aromatic vinyl resin, a polyester resin or a polyolefin resin. The layer (A) may be layered on the layer (B) directly or via another layer (C). The layer (A) may be arranged on both sides of the layer (B), or the layer (B) may be arranged on both sides of the layer (A).

EP 2 392 457 A1

**Description**

TECHNICAL FIELD

The present invention relates to a layered product excellent in sunlight reflectivity and is suitable for back sheets for solar cells, materials with low heat storage, infrared reflective materials and the like.

BACKGROUND ART

Recently, there is a. growing demand for solar cells that have been noticed as energy supplying means alternative to petroleum which is a cause of global warming. With the increase in demand for solar cells, stable supply and cost reduction of parts such as back sheets for solar cells have been required, and also there is a growing demand for improving conversion efficiency of solar cells.
Back sheets for solar cells are layered on an encapsulating resin face after encapsulating a silicon cell under the glass plate with the encapsulating resin such as ethylene vinyl acetate resin.
Conventionally, as the back sheet for solar cells, a white thermoplastic resin sheet layered on each face of a polyester sheet has been used in order to improve reflection of sunlight so as to improve conversion efficiency of solar cells (Patent Documents 1 and 2).
However, further improvement of conversion efficiency of solar cells has been required, and concurrently further improvement of reflection of sunlight has been required for back sheets for solar cells, Also, for applications other than back sheets for solar cells, materials high in reflectivity of light and low in heat storage have been required.
Patent Document 1: Japanese Patent Laid-open No. 2006-270025

Patent Document 2: Japanese Patent Laid-open No. 2007-177136

DISCLOSURE OF THE INTENTION

PROBLEMS TO BE SOLVED BY THE INVENTION

The present invention aims at providing the layered product which is excellent in reflectivity of sunlight and can obtain high conversion efficiency when used for back sheets for solar cells and is excellent in reflectivity of infrared rays and low in heat storage when used for another application.

MEANS FOR SOLVING THE PROBLEM

As a result of intensive studies for solving the above problem, the present inventors have found that use of a layered product which comprises a thermoplastic resin layer comprising titanium oxide particles with a large average particle diameter and a thermoplastic resin layer comprising titanium oxide particles with a small average particle diameter improves reflectivity of sunlight than when any one of the layers is used, and improves conversion efficiency of solar cells when it is used for back sheets for solar cells.
That is, the present invention provides a layered product having a layer (A) and a layer (B), in which said layer (A) is formed of a thermoplastic resin composition comprising 0.1-40 parts by mass of titanium oxide particles per 100 parts by mass of a thermoplastic resin in which the titanium oxide particles have a volume average particle diameter of not less than 0.01 $\mu$m and not more than 0.35 $\mu$m and contain less than 10 mass% of particles of not less than 0.5 $\mu$m in particle diameter relative to the whole particles, and said layer (B) is formed of a thermoplastic resin composition comprising 0.1-40 parts by mass of titanium oxide particles per 100 parts by mass of a thermoplastic resin in which the titanium oxide particles have a volume average particle diameter of not less than 0.5 $\mu$m and not more than 2 $\mu$m and contain less than 10 mass% of particles of not more than 0.35 $\mu$m in particle diameter relative to the whole particles.
In addition, according to preferable embodiments of the present invention, a back sheet for solar cells and a solar cell module are provided, which contain the layered product of the above present invention.

EFFECT OF THE INVENTION

According to the present invention, a layered product comprising a thermoplastic resin layer containing titanium oxide particles with a large average particle diameter and a thermoplastic resin layer containing titanium oxide particles with a small average particle diameter is used as a back sheet of solar cells, and thus conversion efficiency of solar cells can be improved than when either one of the layer is used. This is considered to be because the layered product of the present invention is excellent in reflectivity of sunlight, particularly reflectivity of the infrared region of sunlight. Therefore, the layered product of the present invention is useful as back sheets for solar cells, and also can be widely used as infrared reflective materials and materials with low heat storage.

MODE FOR CARRYING OUT THE INVNETION

Hereinafter, the present invention is described in detail. In this specification, the term "(co)polymer" means homopolymer and copolymer, the term "(meth)acryl" means acryl and/or methacryl, and the term "(meth)acrylate" means acrylate and/or methacrylate.

The layered product of the present invention may comprise at least the above two layers (A) and (B), and may be a layered product in which the above layer (B) is directly layered on the above layer (A) or a layered product in which the above layer (B) is layered on the layer (A) via another light-transmitting resin layer (C). Also, it may be a layered product in which the above layer (A) is directly layered or layered via the above layer (C) on both sides of the above layer (B) as an inner layer. Moreover, it may be a layered product in which the above layer (B) is directly layered or layered via the above layer (C) on both sides of the above layer (A) as an inner layer. Further, the layered product of the present invention may comprise a plurality of the above layer (A), the above layer (B) or the above layer (C).

Typical layer constructions of the layered product of the present invention include two-layer product of layer (A)/layer (B), a three-layer product of layer (A)/layer (C)/layer (B), a three-layer product of layer (A)/layer (B)/layer (A), a three-layer product of layer (B)/layer (A)/layer (B), a five-layer product of layer (A)/layer (C)/layer (B)/layer (C)/layer (A), a five-layer product of layer (B)/layer (C)/layer (A)/layer (C)/layer (B) and a multi-layer product in combination of these. Also, the above layer (A), the above layer (B) and the above layer (C) can be respectively formed of one layer or a plurality of layers, and concrete examples include a three-layer product of layer (A)/layer (A)/layer (B). The layered product of the present invention can be produced by directly joining each layer with methods such as coextrusion and heat-press or may be produced by bonding the respective layers with an adhesive agent.

The layered product of the present invention exhibits good reflectivity of sunlight even when the above layer (A) comprising titanium oxide particles with a small volume average particle diameter is arranged on the light receiving side or when the above layer (B) comprising titanium oxide particles with a large volume average particle diameter is arranged on the light receiving side.

Since titanium oxide particles contained in the above layers (A) and (B) are white pigments, the layered product of the present invention has a white appearance. Therefore, for example, it can be substituted for the conventional white sheet constituting the back sheet for the solar cells. Also, the layered product of the present invention can be used as the back sheet for solar cells as it is. Moreover, the layered product of the present invention may be layered on a heat resistant resin layer, infrared-transmitting colored resin layer or the like to produce a high-performance back sheet for solar cells.

In the present invention, the resins constituting the above layer (A), the above layer (B) and the above layer (C) may be the same resins or resins different from each other. As the resin, a thermoplastic resin is preferably used because the layered product can be easily produced by methods such as coextrusion and heat-press.

The thermoplastic resin includes aromatic vinyl resins (for example, styrene resins, rubber-reinforced styrene resins, acrylonitrile/styrene resins, and resins made of (co)polymers obtained by polymerization of a monomer containing an aromatic vinyl compound, such as (co)polyfners of an aromatic vinyl compound), polyolefin resins (for example, polyethylene resins, polypropylene resins, ethylene-$\alpha$-olefin resins, ethylene/vinyl acetate resins, and the like), polyvinyl chloride resins, polyvinylidene chloride resins, polyvinyl acetate resins, polyester resins, polycarbonate resins, acrylic resins (for example, (co)polymers of (meth)acrylate compounds), fluorocarbon resins and the like. These can be used alone or in combination of two or more. The preferable thermoplastic resin includes an aromatic vinyl resin (I), polyester resin (II) and polyolefin resin (III).

When the thermoplastic resin is amorphous, it has a glass transition temperature of preferably 90-220°C, more preferably 100-200°C and further more preferably 120-180°C due to the balance between flexibility and heat resistance. Meanwhile, when the thermoplastic resin has a plurality of glass transition, temperatures, the higher temperature is to be the glass transition temperature of the thermoplastic resin. For example, when the thermoplastic resin, comprises a resin component and a rubber component, the thermoplastic resin has a glass transition temperature of the resin component and a glass transition temperature of the rubber component, but the glass transition temperature of the resin component is usually higher, and thus the glass transition temperature of the resin component is adopted as the glass transition temperature of the thermoplastic resin.

The layered product of the present invention can be improved in heat resistance by making one of the layers constituting it of a heat resistant layer. For example, when the layered product of the present invention is a three-layer product of layer (A)/layer (C)/layer (B), it can be improved in heat resistance by using, as a thermoplastic resin constituting the layer (C), one with a higher glass transition temperature than the thermoplastic resins constituting the other layers.

Similarly, when the layered product of the present invention is a three-layer product of layer (A)/layer (B)/layer (A) or a five-layer product of layer (A)/layer (C)/layer (B)/layer (C)/layer (A), it can be improved in heat resistance by using, as a thermoplastic resin constituting the layer (B), one with a higher glass transition temperature than the thermoplastic resins constituting the other layers. Similarly, when the layered product of the present invention is a three-layer product of layer (B)/layer (A)/layer (B) or a five-layer product of layer (B)/layer (C)/layer (A)/layer (C)/layer (B), it can be improved in heat resistance by using, as a thermoplastic resin constituting the layer (A), one with a higher glass transition temperature than the thermoplastic resins constituting the other layers. For example, a heat resistant layer can be constituted by a thermoplastic resin having a glass transition temperature of not less than 120°C (preferably 120-220°C) whilst she other layers are constituted by a thermoplastic resin having a lower glass transition temperature than that.

It addition, when the layer product of the present invention requires high heat resistance and flexibility, it is preferable that a thermoplastic resin having a relatively low glass transition temperature is layered on both sides of the heat resistant layer.

Particularly in case of a three-layer product of layer (A)/layer (B)/layer (A), for example, a layered product with not only high heat resistance but also flexibility can be obtained by forming the layer (B) of a highly heat-resistant thermoplastic resin having a glass transition temperature of not less than 150°C, and forming the layer (A) of a thermoplastic resin having a lower glass transition temperature (for example, 120-140°C) than that.

Examples of the aromatic vinyl resin (I) used as the thermoplastic resin in the present invention include a rubber-reinforced aromatic vinyl resin (I-1) obtained by polymerization of a monomer (b) comprising an aromatic vinyl compound in the presence of a rubbery polymer (a), a (co)polymer (I-2) of a monomer (b) comprising an aromatic vinyl compound, and a mixture of the rubber-reinforced aromatic vinyl resin (I-1) and the (co)polymer (I-2) .

The (co)polymer (I-2) can be obtained by polymerisation of the monomer (b) comprising an aromatic vinyl compound in the absence of the rubbery polymer (a). The rubber-reinforced aromatic vinyl resin (I-1) usually includes copolymers in which the monomer (b) comprising an aromatic vinyl compound is graft-copolymerized onto the rubbery polymer (a) and an ungrafted component (which is of the same type as the above (co)polymer (I-2)) which fails to graft onto the rubbery polymer. Further, the rubbery polymer (a) to which the monomer (b) comprising an aromatic vinyl compound is not grafted may be included. A preferable thermoplastic resin includes an aromatic vinyl resin (I) comprising the above rubber-reinforced aromatic vinyl resin (I-1) and optionally the above (co)polymer (I-2).

Preferable, the aromatic vinyl resin (I) of the present invention comprises at least one kind of the rubber-reinforced aromatic vinyl resin (I-1) from the viewpoint of impact resistance and flexibility, and may contain the (co)polyiner (I-2), if required. The content of the rubbery polymer (a) is preferably 5-40 parts by mass, more preferably 8-30 parts by mass, furthermore preferably 10-20 parts by mass, and particularly preferably 12-18 parts by mass relative to 100 parts by mass of the aromatic vinyl resin (I). When the content of the rubbery polymer (a) exceeds 40 parts by masts, heat resistance is not sufficient, and processing into a film may be difficult. On the other hand, when the content of the rubbery polymer (a) is less than 5 parts by mass, impact resistance and flexibility may be insufficient.

Heat resistance of the aromatic vinyl resin (I) can be improved by using, as the monomer (b), a maleimide compound in addition to the aromatic vinyl compound. The content of the maleimide compound unit is usually preferably 0-30 mass%, more preferably 1-30 mass%, furthermore preferably 5-27 mass%, still furthermore preferably 10-27 mass% and particularly preferably 15-25 mass% relative to 100 mass% of the aromatic vinyl resin (I). When the content of the maleimide compound unit is less than 1 weight%, heat resistance may be insufficient, and when the content of the maleimide compound unit exceeds 30 mass%, flexibility for a film may be insufficient. Also, the maleimide compound unit may be originated from the rubber-reinforced aromatic vinyl resin (I-1) or may be originated from the (co)polymer (I-2). The glass transition temperature of the aromatic vinyl resin (I) can be adjusted by the content of the maleimide compound unit as described later, and the (co)polymer (I-2) comprising the maleimide compound unit is advantageous for preparing the aromatic vinyl resin (I) having a desired glass transition temperature. Meanwhile, the glass transition temperature of the aromatic vinyl resin (I) can be adjusted by blending additives or fillers such as plasticizers and inorganic fillers.

The above rubbery polymer (a) includes but is not particularly limited to conjugated-diene rubbers such as polybutadiene, butadiene/styrene random copolymers, butadiene/styrene block copolymers and butadiene/acrylonitrile copolymers, and hydrogenated products thereof (that is, hydrogenated conjugated diene rubbers) as well as non-diene rubbers such as ethylene-$\alpha$-olefin rubbers, acrylic rubbers, silicone rubbers and silicone/acrylic composite rubbers, and these, can be used alone or in combination of two or more.

Among these, ethylene-$\alpha$-olefin rubbers (a-1), hydrogenated conjugated-diene rubbers (a-2), acrylic rubbers (a-3), silicone rubbers (a-4) and silicone/acrylic composite rubbers (a-5) are preferable from the viewpoint of weatherability. Among them, acrylic rubbers (a-3), silicons rubbers (a-4) and silicone/acrylic composite rubbers (a-5) are more preferable, and silicone/acrylic composite rubbers (a-5) are particularly preferable from the viewpoint of flexibility. These can be used alone or in combination of two or more.

Examples of ethylene-$\alpha$-olefin rubbers (a-1) include ethylene-$\alpha$-olefin copolymers and ethylene-$\alpha$-olefin-non-conjugated diene copolymers. Examples of the ($\alpha$-olefin constituting the ethylene-$\alpha$-olefin rubber (a-1) include an $\alpha$-

olefin with 3-20 carbon atoms, and concretely, propylene, 1-butene, 1-pentene, 1-hexene, 4-methyl-1-pentene, 1-heptene 1-octene, 1-decene, 1-dodecene, 1-hexadecene and 1-eicocene. These α-olefins can be used alone or in combination of two or more. The number of carbon atoms of the α-olefin is preferably 3-20, more preferably 3-12, and furthermore preferably 3-8. When the number of carbon atoms exceeds 20, copolymerizability is lowered, and surface appearance of molded articles may become insufficient. As a typical ethylene-α-olefin rubber (a-1), ethylene/propylene copolymers, ethylene/propylene/non-conjugated diene copolymers, ethylene/1-butene copolymers and ethylene/1-butene/non-conjugated diene copolymers are include. The mass ratio of ethylene/α-olefin is preferably 5-95/95-5, more preferably 50-90/50-10 and furthermore preferably 60-85/40-15. When the mass ratio of α-olefin exceeds 95, weatherability is not sufficient. On the other hand, when it is less than 5, rubber elasticity of the rubbery polymer is not sufficient, and thus flexibility for a film may be insufficient.

The non-conjugated diene includes alkenyl norbornenes, cyclic dienes and aliphatic dienes, and preferably includes 5-ethylidene-2-norbornene and dicyclopentadiene. These non-conjugated dienes can be used alone or in combination of two or more. The ratio of the non-conjugated diene is preferably 0-30 mass%, more preferably 0-20 mass% and furthermore preferably 0-10 mass% relative to the total amount of the ethylene-α-olefin rubbers (a-1). When the ratio of the non-conjugated diene exceeds 30 mass%, appearance of molded articles and weatherability may be insufficient. The amount of unsaturated groups in the ethylene-α-olefin rubber (a-1) is preferably in a range of 4-40 in terms of iodine value.

Mooney viscosity ($ML_{1+4}$, 100°C; according to JIS K6300) of the ethylene-α-olefin rubber (a-1) is preferably 5-80, more preferably 10-65 and furthermore preferably 15-45, When the Mooney viscosity of the Component (a-1) exceeds 80, may become difficult, and when the Moon viscosity of the Component is less than 5, impact resistance and flexibility for a film may be insufficient.

The hydrogenated conjugated diene rubber (a-2) includes, for example, hyd-rogenated products of the conjugated diene block copolymer having the following structure, That is, a block copolymer comprising two or more of a polymer block A composed of an aromatic vinyl compound unit, a polymer block B in which 95 mol% or more of the double bonds of a polymer made from a conjugated diene compound unit with a 1,2-vinyl bond content of more than 25 mol% is hydrog-enated, a polymer block C in which 95 mol% or more of the double bonds of a polymer made from a conjugated diene compound unit with a 1,2-vinyl bond content of not more than 25 mol% is hydrogenated, and a polymer block D in which 95 mol% or more of the double bonds of a copolymer of an aromatic vinyl compound unit with a conjugated diene compound unit is hydrogenated.

Examples of aromatic vinyl compounds used for the production of the above polymer block A include styrene, α-methyl styrene and other methyl styrenes, vinyl xylene, monochlorostyrene, dichlorostyrene, monobromostyrene, dibromostyrene, fluorostyrene, p-t-butylstyrene, ethylstyrene and vinylnaphthalene, and these can be used alone or in combination of two or more. Above all, preferable one is styrene. The ratio of a polymer block A in the block copolymer is preferably 0-65 mass% and further preferably 10-40 nass%. When the polymer block A exceeds 65 mass%, impact resistance may be insufficient.

The above polymer blocks B, C and D can be obtained by hydrogenating a polymer of a conjugated diene compound. The conjugated diene compound used for the production of the above polymer blocks B, any D include, for example, 1,3-butadiene, isoprene, 1,3-pentadiene and chloroprene, but in order to obtain the hydrogenated conjugated diene rubbers (I-2) which can be utilized industrially and is excellent in property, 1,3-butadiene and isoprene are preferable. These can be used alone or in combination of two or more. The aromatic vinyl compound used for the production of the above polymer block D includes the same as the aromatic vinyl compound used for the production of the above polymer block A, and these can be used alone or in combination of two or more. Above all, preferable one is styrene.

The hydrogenation ratio of the above polymer blocks B, C and D is 95 mol% or more, and preferably 96 mol% or more. When it is less than 95 mol%, gelation occurs during polymerization, and thus polymerization may not be stably performed. The 1,2-vinyl bond content of the polymer block B is preferably more than 25 mol% and not more than 90 mol%, and further preferably 30-80 mol%. When the 1,2-vinyl bond content of the polymer block B is not more than 25 mol%, rubbery properties are lost so that impact resistance may be insufficient, and when it exceeds 90 mol%, chemical resistance may be insufficient. The 1,2-vinyl bond content of the polymer block C is preferably not more than 25 mol%, and further preferably not more than 20 mol%. When the 1,2-vinyl bond content of the polymer block C exceeds 25 mol%, scratch resistance and sliding properties may not be exhibited sufficiently. The 1,2 -vinyl bond content of the polymer block D is preferably 25-90 mol%, and further preferably 30-80 mol%. When the 1,2-vinyl bond content of the polymer block D is less than 25 mol%, rubbery properties are lost so that impact resistance may be insufficient, and when it exceeds 90 mol%, chemical resistance may not be obtained sufficiently. Also, the content of the aromatic vinyl compound of the polymer block D is preferably not more than 25 mass% and further preferably not more than 20 mass%. When the content of an aromatic vinyl compound of the polymer block D exceeds 25 mass% rubbery properties are lost so that impact resistance may be insufficient.

The molecular structure of the above block copolymer may be branched, radial or in combination of these, and the block structure thereof may be diblock, triblock or multiblock or a combination of these. Examples are block copolymers represented by A-(B-A)$_n$, (A-B)$_n$, A-(B-C)$_n$, C-(B-C)$_n$, (B-C)$_n$, A-(D-A)$_n$, (A-D)$_n$, A-(D-C)$_n$, C-(D-C)$_n$, (D-C)$_n$, A-(B-C-D)$_n$ or (A-B-C-D)$_n$ (where n is an integer of not less than 1), and preferably a block copolymer having a structure of A-B-A, A-B-A-B, A-B-C, A-D-C or C-B-C.

The weight average molecular weight (Mw) of the above hydrogenated conjugated diene rubber (a-2) is preferably 10,000-1,000,000, more preferably 30,000-800,000, and further more preferably 50,000-500,000. When Mw is less than 10,000, flexibility for a film may be insufficient, and on the other hand, when it exceeds 1,000,000, polymerization may be difficult.

The acrylic rubber (a-3) is a polymer of an alkyl acrylate having an alkyl group with 2-8 carbon atoms. Concrete examples of the alkyl acrylate include ethyl acrylate, propyl acrylate n-butyl acrylate, isobutyl acrylate, hexyl acrylate, n-octyl acrylate and 2-ethylhexyl acrylate. These can be used alone or in combination of two or more. A preferable alkyl acrylate is (n-, i-)butyl acrylate or 2-ethylhexyl acrylate. A part of the alkyl acrylate can be substituted by another copolymerizable monomer in an amount of 20 mass% at maximum. Another monomer as above includes, for example, vinylchloride, vinylidene chloride, acrylonitrile, vinylester, alkyl methacrylate, methacrylic acid, acrylic acid and styrene.

It is preferable that kinds and amounts of monomers to be copolymerized for the acrylic rubber (a-3) are selected so that it has a glass transition temperature of not more than -10°C Also, it is preferable to appropriately copolymerize a crosslinkable monomer in the acrylic rubber, and the amount of the crosslinkable monomer to be used is usually 0-10 mass%, preferably 0.01-10 mass% and further preferably 0.1-5 mass% as a proportion relative to the acrylic rubber (a-3).

Concrete examples of the crosslinkable monomer include mono or polyethylene glycol diacrylates such as ethylene glycol diacrylate, diethylene glycol diacrylate, triethylene glycol diacrylate, tetraethylene glycol diacrylate, mono or polyethylene glycol dimethacrylates such as ethylene glycol dimethacrylate, diethylene glycol dimethacrylate, triethylene glycol dimethacrylate, tetraethylene glycol dimethiacrylate, di or triallyl compounds such as divinylbenzene, diallylphthalate, diallylmaleate, diallylsuccinate and triallyltriazine, allyl compounds such as allylmethacrylate and allylacrylate, and conjugated diene compounds such as 1,3-butadiene. The above acrylic rubber is produced by known polymerization methods, and a preferable polymerization method is emulsion polymerization.

As the silicone rubber (a-4), all which can be obtained by known polymerization methods can be used, and polyorganosiloxane rubbery polymer latex obtained in a form of latex by emulsion polymerization is preferable from the view point of easiness of graft polymerisation.

The latex of the polyorganosiloxane rubbery polymer can be obtained by the known method described in, for example, US patient Nos. 2,891,920 and 3,294,725 specifications. For example, a method in which an organosiloxane and water are shear-mixed and then condensation-polymerized in the presence of a sulfonic acid emulsifier such as alkylbenzene sulfonic acid and alkylsulfonic acid using a homomixer or ultrasonic mixer. The alkylbenzene sulfonic acid is suitable because it acts as an emulsifier for the organosiloxane as well as a polymerization initiator. In this instance, it is preferable to use an alkylbenzene sulfonic acid metal salt or alkylsulfonic acid metal salt in combination, because they are effective for maintaining polymers to be stable during graft polymerization. If necessary, a grafting agent or crosslinking agent may be condensation-polymerized together to an extent that does not impair the aimed property of the present invention.

The organosiloxane to be used is, for example, one having a structural unit represented by the general formula $R_mSiO_{(4-m)/2}$ (wherein R is a substituted or unsubstituted monovalent hydrocarbon group, and m indicates an integer of 0 to 3), and has a linear, branched or cyclic stricture, and is preferably an organosiloxane having a cyclic structure. The substituted or unsubstituted monovalent hydrocarbon group of the organosiloxane includes, for example, methyl group, ethyl group, propyl group, phenyl group and these hydrocarbon groups substituted with a cyano group or the like.

Concrete examples of the organosiloxane include cyclic compounds such as hexamethylcyclotrisiloxane, octamethylcyclotetrasiloxane, decamethylcyclopentasiloxane, dodecamethylcyclohexasiloxane, trimethyltriphenylcyclotrisiloxane, and a linear or branched organosiloxane. These can be used alone or in combination of two or more.

The organosiloxane may be a polyorganosiloxane that is previously condensation-polymerized to have a polystyrene-equivalent weight-average molecular weight of, for example, about 500-10,000. Also, when the organosiloxane is a polyorganosiloxane, a molecular chain terminal thereof may be blocked, for example, by hydroxyl group, alkoxy group, trimethylsilyl group, dimethylvinylsilyl group, methylphenylvinylsilyl group and methyldiphenylsilyl group.

As the grafting agent, for example, a compound having both unsaturated group and alkoxysilyl group can be used. Concrete examples of such a compound include p-vinylphenylmethyldimethoxysilane, 1-(m-vinyiphenyl)methyldimethylisopropoxysilane, 2-(p-vinylpheny)ethylmethyldimethoxysilane, 3-(p-vinylphenoxy)propylmethyldiethoxysilan, 3-(p-vinylbenzoyloxy)propylmethyldimethoxysilane, 1-(o-vinylphenyl)-1,1,2-trimethy-2,2-dimethoxydsilane, 1-(p-vinylphenyl)-1,1-diphenyl-3-ethyl-3-,3-diethoxydisiloxane, m-viriylphenyl-[3-(triethoxysilyl)propy]diphelsilane, [3-(p-isopropenylbenzoylamino)propyl]phenyldipropoxysilane, 2-(m-vinylphenyl)ethylmethyldimethoxysilane, 2-(o-vinylphenyl) ethylmethyldimethoxysilane, 1-(p-vinylpheny]ethylmethyldimethoxysilane, 1-(m-vinylphenyl)ethylmethyldimethoxysilane, 1-(o-vinylphenyl)ethylmethyldimethoxysilane, and a mixture of these. Of these, p-vinylphenylmethyldimethoxysilane, 2-(p-vinylphenyl/ethylmethyldimethoxysliane, and 3-(p-vinylbenzoyloxy)propylmethyldimethoxysilane are preferable, and p-vinylphenylmethyldimethoxysilane is further preferable.

The ratio of the grafting agent to be used is usually 0-10 parts by mass, preferably 0.2-10 parts by mass and further preferably 0.5-5 parts by mass relative to 100 parts by mass of the total amount of the organosiloxane, grafting agent and crosslinking agent. When the amount of the grafting agent to be used is too much, the molecular weight of the grafted vinyl polymer is lowered, and as a result, sufficient impact resistance cannot be obtained. In addition, oxidative degradation easily proceeds at double bonds of the grafted polyorganosiloxane rubbery polymer, and thus a graft copolymer with good weatherability cannot be obtained.

An average particle diameter of particles of the polyorganosiloxane rubbery polymer latex is usually not more than 0.5 $\mu$m, preferably not more than 0.4 $\mu$m, and further preferably 0.05-0.4 $\mu$m, The average particle diameter can be easily controlled, by amounts of the emulsifier and water, a degree of dispersion upon mixing with the homomixer or ultrasonic mixer, or a way of charging the organosiloxane. When the average particle diameter of latex particles exceeds 0.5 $\mu$m, gloss is inferior.

The polystyrene-equivalent weight-average molecular weight of the polyorganosiloxane rubbery polymer obtained as above is usually 30,000-1,000,000, and preferably 50,000-300,000, When the weight average molecular weight is less than 30,000, flexibility for a film may be insufficiently. On the other hand, when the weight-average molecular weight exceeds 1,000,000, entanglement within rubber polymer chains becomes strong, and rubber elasticity is lowered, and thus flexibility for a film is lowered, or graft particles are hardly melted, and film appearance may be impaired.

The weight-average molecular weight can be easily controlled by changing temperature and time of condensation polymerization during preparation of polyorganosiloxane rubbery polymers. That is, the lower the temperature of condensation polymerization is and/or the longer the cooling time is, the higher the molecular weight of the polymer is. Also, the polymer can be made high in molecular weight by adding a small amount of a crosslinking agent.

Meanwhile, the molecular chain terminal of the polyorganosiloxane rubbery polymer may be blocked, for example, by hydroxyl group, alkoxy group, trimethylsilyl group, dimethylvinylsilyl group, methylphenylvinylsilyl group or methyldiphenylsilyl group.

The amount of the emulsifier to be used is usually 0.1-5 parts by mass and preferably 0.3-3 parts by mass relative to 100 parts by mass of the total of the organosiloxane, grafting agent and crosslinking agent. The amount of water to be used in this instance is usually 100-500 parts by mass and preferably 200-400 parts by mass relative to 100 parts by mass of the total of the organosiloxane, grafting agent and crosslinking agent. The condensation polymerization temperature is usually 5-100°C.

During production of the polyorganosiloxane rubbery polymer, a crosslinking agent can be added as the third component in order to improve impact resistance of the resulting graft copolymer. The crosslinking agent includes, for example, trifunctional crosslinking agents such as methyl trimethoxysilane, phenyl trimethoxysilane and ethyl triethoxysilane, and tetrafunctional crosslinking agents such as tetraethoxysilane. These can be used in combination of two or more. As these crosslinking agents, crosslinked pre-polymers that are previously condensation-polymerized can be used. The addition amount of the crosslinking agent is usually not more than 10 parts by mass, preferably not more than 5 parts by mass and further more preferably 0.01-5 parts by mass relative to 100 parts by mass of the total amount of the organosiloxane, grafting agent and crosslinking agent. When the addition amount of the above crosslinking agent exceeds 10 parts by mass, flexibility of polyorganosiloxane rubbery polymers may be impaired so that flexibility for a film may be lowered.

The silicone/acrylic composite rubber (a-5) means a rubbery polymer comprising a polyorganosiloxane rubber and polyalkyl (meth)acrylate rubber. A preferable silicone/acrylic composite rubber (a-5) is a composite rubber having a structure in which a polyorganosiloxane rubber and a polyalkyl (math) aery-late rubber are entangled with each other so as to be inseparable.

The above polyalkyl (meth)acrylate rubber includes, for example, one which can be obtained by copolymerizing an alkyl (meth)acrylate (monomer) such as methyl acrylate, ethyl acrylate, n-propyl acrylate, n-butyl acrylate, 2-ethylhexyl acrylate, ethoxyethoxyethyl acrylate, methoxy tripropylene glycol acrylate, 4-hydroxybutyl acrylate, lauryl methacrylate and stearyl methacrylate. These alkyl (meth)acrylates can be used alone or in combination of two or more.

The above alkyl (meth)acrylate monomer may further comprise various vinyl monomers including aromatic vinyl compounds such as styrene, $\alpha$-methyl styrene and vinyl toluene; vinyl cyanide compounds such as acrylonitrile and methacrylonitrile, silicones modified with methacrylic acids; and fluorine-containing vinyl compounds in a range of not more than 30 mass% as comonomers.

The above polyalkyl (meth)acrylate rubber is preferably a copolymer having two or more glass transition temperatures. Such a polyalkyl (meth)acrylate rubber is preferable in order to exhibit flexibility of films.

As the above polyorganosiloxane rubber, can be used one resulting from eopolymerization of an organosiloxane. The above organosiloxane includes a variety of reduced products with 3- or more membered ring, and preferably includes, for example, hexamethylcyclotrisiloxane, octarnethylcyclotetrasiloxane, decamethylcyclopentasiloxane, dodecamethylcyclohexasiloxane, trimethyltrriphenylcyclotrisiloxane, tetramethyltetraphenylcyclotetrasiloxane and octaphenylcyclotetrasiloxane. These organosiloxanes can be used alone or in combination of two or more. The amount of these organosiloxanes to be used is preferably not less than 50 mass%, and more preferably not less than 70 mass% relative to the polyorganosiloxane rubber components.

A silicone/acrylic composite rubber (a-5) can be produced, for example, by methods described in such as JP-A-H04-239010 and JP-B-2137934, As such a silicone/acrylic composite rubber graft copolymer, "METABLENE SX-006 (trade name)" manufactured by MITSUBISHI RAYON CO., LTD. is commercially available,

The monomer (b) comprising an aromatic vinyl compound in the present invention typically includes a monomer comprising only an aromatic vinyl compound and a monomer comprising both an aromatic vinyl compound and a vinyl cyanide compound, and is preferably one comprising both an aromatic vinyl compound and a vinyl, cyanide compound.

The aromatic vinyl compounds include, for example, styrene, styrene, o-methyl styrene, p-methyl styrene, vinyl toluene, vinyl xylene, ethyl styrene, dimethyl styrene, p-t-butyl styrene, vinyl naphthalene, methoxy styrene, monobromo styrene, dibromo styrene, tribromo styrene and fluorostyrene. Of these, styrene and a-methyl styrene are preferable. These aromatic vinyl compounds can be used alone or in combination of two or more.

The vinyl cyanide compounds include acrylonitrile, methacrylonitrile and $\alpha$-chloro(meth)acrylonitrile. Of these, acrylonitrile is preferable. These vinyl cyanide compounds can be used alone or in combination of two or more.

As the monomer (b) comprising an aromatic vinyl compound may comprise another compound copolymerizable with the aromatic vinyl compound or the vinyl cyanide compound. Such another compound includes (meth)acrylates, maleimide compounds, other functional group-containing unsaturated compounds (for example, unsaturated acids, epoxy group-containing unsaturated compounds, hydroxyl group-containing unsaturated compounds, oxazoline group-containing unsaturated compounds and acid anhydride group-containing- unsaturated compounds). These can be used alone or in combination of two or more. The amount of such another compound to be used is preferably 0-50 mass%, more preferably 1-40 mass% and further more preferably 1-30 mass%, provided that the monomer (b) comprising the aromatic vinyl compound is 100 mass%,

The (meth)acrylate includes, for example, methyl (meth)acrylate, ethyl (meth)acrylate, n-propyl (meth)acrylate, isopropyl (meth)acrylate, n-butyl (meth)aerylate and isobutyl (meth)acrylate. These can be used alone or in combination of two or more. Of these, methyl methacrylate is preferable.

The unsaturated acid includes, for example, acrylic acid, methacrylic acid, itaconic acid and maleic acid. These can be used alone or in combination of two or more.

The maleimide compound includes, for example, maleimide, N-methylmaleimide, N-butylmaleimide, N-phenylmaleimide and N-cyclohexylmaleimide. These can be used alone or in combination of two more. In order to introduce a maleimide compound unit into a copolymerized resin, maleic anhydride may be first (co)polymerized, followed by imidation. Containing a maleimide compound as another copolymerizable compound is preferable from the viewpoint of improving heat resistance of the thermoplastic resin.

The content of the maleimide compound is usually preferably 0-30 mass%, more preferably 1-30 mas%, further more preferably 5-27 mass%, still furthermore preferably 10-27 mass% and particularly preferably 15-25 mass% as the content of the repeating units derived from the maleimide compound relative to 100 mass% of the above thermoplastic resin. When the content of the repeating units derived from the maleimide compound is less than 1 mass%, heat resistance may be insufficient. On the other hand, when it exceeds 30 mass%, flexibility for a film may be insufficient.

The epoxy group-containing unsaturated compound includes, for example, glycidyl acrylate, glycidyl methacrylate and allyl glycidyl ether, and these can be used alone or in combination of two or more.

The hydroxyl group-containing unsaturated compound includes, for example, 3-hydroxy-1-propene, 4-hydroxy-1-butene, cis-4-hydroxy"2-butene, trans-4-hydroxy-2-butene, 3-hydroxy-2-methyl-1-propene, 2-hydroxyethyl acrylate, 2-hydroxyethyl methacrylate and hydroxystyrene. These can be used alone or in combination of two or more.

The oxazoline group-containing unsaturated compound includes, for example, vinyl oxazoline. These can be used alone or in combination of two or more,

The acid anhydride group-containing unsaturated compound includes, for example, maleic anhydride, itaconic anhydride and citraconic anhydride. These can be used alone or in combination of two or more.

As the above monomer (b) comprising the aromatic vinyl compound, one which is mainly composed of an aromatic vinyl compound and a vinyl cyanide compound is preferable, and the total amount of these compounds is preferably 70-100 mass% and further preferably 80-100 mass% relative to the total amount of the monomer (b) comprising the aromatic vinyl compound. The ratio of an aromatic vinyl compound and an vinyl cyanide compound to be used is preferably 5-95 mass% and 5-95 mass%, more preferably 50-95 mass% and 5-50 mass%, further more preferably 60-95 mass% and 5-40 mass% and particularly preferably 65-85 mass% and 15-35 mass% respectively, provided that the total of these is 100 mass%.

When the aromatic vinyl resin (I) is used as the thermoplastic resin, a rubber-reinforced aromatic vinyl resin which comprises a rubber-reinforced aromatic vinyl resin (I-1') obtained by polymerization of a monomer (b) comprising an aromatic vinyl compound in the presence of a rubbery polymer (a) selected from the group consisting of acrylic rubbers (a-3), silicone rubbers (a-4) and silicohe/acrylic composite rubbers (a-5) and optionally a (co)polymer (I-2') of a monomer (b) comprising the aromatic vinyl compound is preferably used from the viewpoint of weatherability and flexibility of these, preferable are a silicone/acrylic composite rubber-reinforced styrene resin using a silicone/acrylic composite rubber (a-5) as the rubbery polymer (a), and a mixture of a silicon rubber-reinforced styrene resin using a silicone rubber (a-4) as the rubbery polymer (a) and an acrylic rubber-reinforced styrene resin using an acrylic rubber (a-3) as the rubbery polymer (a), and particularly preferable is the silicone/acrylic composite rubber-reinforced styrene resin.

The rubber-reinforced aromatic vinyl resin (I-1) can be obtained by known polymerization methods such as emulsion polymerization, suspension polymerization, solution polymerization, bulk polymerization and polymerization methods in combination of these.

The graft ratio of the rubber-reinforced aromatic vinyl resin (I-1) is preferably 20-170%, more preferably 30-170%, further more preferably 30-150% and particularly preferably 40-100%. When the graft ratio is too low, flexibility for a film may be insufficient. When it is too high, viscosity of the thermoplastic resin becomes high so that a thin product of a film may be difficult to make.

The graft ratio can be determined by the following equation (1).

$$\text{Graft ratio (mass\%)} = \{(S - T) / T\} \times 100 \cdots (1)$$

In the above equation, S is the mass (g) of insoluble matter obtained by adding 1 g of the rubber-reinforced aromatic vinyl resin (I-1) to 20 ml of acetone (but acetonitrile when an acrylic rubber is used), shaking the mixture for 2 hours by a shaker under the temperature of 25°C, and then centrifuging the mixture by a centrifuge (at a rotation speed of 23,000 rpm) for 60 minutes under the temperature of 5°C to separate the insoluble matter from soluble matter, and T is the mass (g) of the rubbery polymer contained in 1 g of the rubber-reinforced aromatic vinyl resin (I-1). The mass of the rubbery polymer can be obtained by a method of calculating based on polymerisation prescription and polymerization conversion, a method of determining from infrared absorption spectrum (IR) and the like.

Meanwhile, the graft ratio can be adjusted by appropriately selecting, for example, kind and amount of a chain transfer agent used in the production of the rubber-reinforced aromatic vinyl resin (I-1), kind and amount of a polymerization initiator, method of addition and duration of addition of monomer components during polymerization, and polymerization temperature.

The limiting viscosity [η] (measured at 30°C in methyl ethyl ketone) of the soluble matter in acetone (but acetonitrile when acrylic rubber is used) of the rubber-reinforced aromatic vinyl resin (I-1) is preferably 0.1 to 2.5 dl/g, more preferably 0.2 to 1.5 dl/g, and further more preferably 0.25 to 1.2 dl/g. It is preferable that the limiting viscosity is within this range from the viewpoint of processability of a film and thickness accuracy of layered products.

The limiting viscosity [η] of the soluble matter in acetone (but acetonitrile when acrylic rubber is used) of the rubber-reinforced aromatic vinyl resin (I-1) is measured by the following method. First, the soluble matter in acetone (but acetonitrile when acrylic rubber is used) of the rubber-reinforced, aromatic vinyl resin (I-1) is dissolved in methyl ethyl ketone to make five samples different in concentration. Then, the limiting viscosity [η] is obtained from the results of a reduced viscosity measured at each concentration at 30°C using the Ubbelohde viscometer tube. The unit is dl/g.

The limiting viscosity [η] can be adjusted by appropriately selecting, for examples, kind and amount of a chain transfer agent used in the production of the rubber-reinforced aromatic vinyl resin (I-1), kind and amount of a polymerization initiator, method of addition and duration of addition of monomer components during polymerization, and polymerization temperature. Also, it can be adjusted by appropriately selecting and blending (co)polymers (I-2) different limiting viscosity [η].

A polyester resin (II) used as a thermoplastic resin in the present invention includes, for examples, polymers obtained by condensation-polymerization of a diol and a dicarboxylic acid. Examples of the dicarboxylic acid include terephthalic acid, isophthalic acid, phthalic acid, naphthalene dicarboxylate, adipic acid and sebacic acid. Examples of the diol include ethylene glycol, trimethylena glycol, tetramethylene glycol, cyelohexanedimethanol and propanediol. Concrete examples of the polyester resin (II) include polyethylene terephthalate (PET), polybutylene terephthalate (PBT), polytetramethylene terephthalate, polyethylene-p-oxybenzoate, poly-1,4-cyclohexylene dimethylene terephtalate (PCHDMT), polyethylene-2,6-naphthalene dicarboxylate (PEN) and polypropylene terephthalate (PPT). Of these, PET and PEN are preferable.

The polyolefin resin (III) used as a thermoplastic resin in the present invention includes, for example, homopolymers of ethylene or α-olefin, copolymers mainly composed of ethylene or α-olefin with another monomer, ethylene/α-olefin copolymers, unsaturated group-containing copolymers of ethylene and/or α-olefin with conjugated diene and/or non-conjugated diene and copolymers of ethylene and/or α-olefin with acrylic acid, methacrylic acid or vinyl acetate. Preferable concrete examples of the polyolefin resin (III) include ethylene based (co)polymers (resins) such as polyethylene, ethylene-propylene copolymer, ethylene-butene copolymer, ethylene-4-methyl-1-pentene copolymer, ethylene-vinyl acetate copolymer and ethylene-(meth)acrylic acid copolymer; and polypropylene (co)polymers (resins) such as polypropylene.

Ethylene based (co)polymers include a polyethylene resin comprising at least one selected from the group consisting of low density polyethylene, linear low density polyethylene, linear ultra low density polyethylene, medium density polyethylene and high density polyethylene; copolymers mainly composed of ethylene with $\alpha$-olefin, that is, copolymers of ethylene with an $\alpha$-olefin having 3-10 carbon atoms such as propylene, 1-butene, 1-pentene, 1-hexene, 1-heptene and 1-octene; copolymers of ethylene with a vinyl ester such as vinyl acetate and vinyl propionate; copolymers of ethylene with an unsaturated carboxylate such as methyl acrylate, ethyl acrylate, methyl methacrylate and ethyl methacrylate; copolymers of ethylene with an unsaturated compound such as conjugated diene and non-conjugated diene; multi-component copolymers of ethylene with two or more selected from the above various comonomers; mixed resins comprising combinations of two or more selected from the above polyethylene resins, the above various copolymers and the above multi-component copolymers, The content of the ethylene units of these ethylene based (co)polymers usually exceeds 50 mass%".

Preferable ethylene based (co)polymers include a resin comprising at least one selected from the group consisting of low density polyethylene, linear low density polyethylene, linear ultra low density polyethylene, ethylene-vinyl acetate copolymer, ethylene-acrylate copolymer and ethylene methacrylate copolymer.

More preferable ethylene based (co)polymers include a linear low density polyethylene having a density of 0.90-0.95 g/cm$^3$ and a melt flow rate (which, hereinafter, may be referred to as "MFR" which is measured in accordance with JTS K7210 at a temperature of 190°C with a load of 21.18N whilst this is the case for other MFR) of 0.2-20 g/10 min. When the density is in the above range, ethylene based (co)polymers advantageously have an appropriate crystallinity so that films may not be so hard but good in flexibility and resiliency. From the viewpoint of these, ethylene based polymers has a density of more preferably 0.90-0.94 g/cm$^3$ and further more preferably 0.91-0.94 g/cm$^3$. Also, when MFR is 0.2 g/10 min or more, extrusion moldability of ethylene based (co)polymers may be stable, and when it is 20 g/10 min or less, a stable film-molding is possible, and uneven thickness or lowering or variation of mechanical strength can be eliminated, advantageously. From the viewpoint of these, ethylene based (co)polymers has an MFR of more preferably 0.5-18 g/10 min and further more preferably 1-15 g/10 min.

Another more preferable ethylene based (co) polymer includes an ethylene-vinyl acetate copolymer having a vinyl acetate content of 10-60 mass% and an MFR of 0.2-20 g/10 min. When the vinyl acetate content is 10 mass% or more, ethylene-vinyl acetate copolymers have a low crystallinity, and thus films which are not so hard can be obtained, good flexibility and resiliency can be obtained, and surface stickiness is also easily exhibited, advantageously. When the vinyl acetate content is 60 mass% or less, heat resistance and film strength are well ensured, bleed out can be inhibited even when an antifogging agent is added, and also surface stickiness is not so strong that unwinding and appearance of films can be improved, advantageously. From the viewpoint of these, the vinyl acetate content of ethylene-vinyl acetate copolymers is more preferably 10-58 mass% and furthermore preferably 12-56 mass%. Also, when MFR is 0.2 g/10 main or more, extrusion moldability of ethylene-vinyl acetate (co)polymers may become stable, and when it is 20 g/10 min or less, a stable film-molding is possible, and uneven thickness or lowering or variation of mechanical, strength may be eliminated, advantageously, From the viewpoint of these, ethylene-vinyl acetate (co)polymers have an MFR of more preferably 0.5-18 g/10 min and further more preferably 1-15 g/10 min.

The production method for the above ethylene based (co)polymer is not particularly limited, and examples of a known polymerization method using a known catalyst for olefin polymerization include slurry polymerization, solution polymerization, bulk polymerization and vapor-phase polymerization using a multi-site catalyst represented by a Ziegler-Natta catalyst and a single site catalyst represented by a metallocene catalyst, or bulk polymerization using a radical initiator.

Titanium oxide particles blended with the layers (A) and (B) of the present invention, are not particularly limited as long as they are used as a pigment, and may be titanium oxide such as of anatase form and rutile form. From the viewpoint of thermostability and weatherability, rutile titanium oxide particles are preferably used.

The volume average particle diameter of titanium oxide particles blended with the layer (A) is not less than 0.01 $\mu$m and not more than 0.35 $\mu$m, and 0.05 $\mu$m to 0.30 $\mu$m is preferable and 0.1 $\mu$m to 0.30 $\mu$m is more preferable. When the volume average particle diameter is less than 0.01 $\mu$m, dispersibility of titanium oxide is deteriorated, and when it exceeds 0.35 $\mu$m, conversion efficiency of the solar cell is not drastically improved, Also, the content of particles having a particle diameter of not less than 0.5 $\mu$m in the titanium oxide particles blended with the layer (A) is less than 10 mass%, preferably less than 5 mass%, more preferably less than 3 mass% and particularly preferably 2 mass% relative to the whole titanium dioxide particles. When the content of particles having a particle diameter of not less than 0.5 $\mu$m is not less than 10 mass%, conversion efficiency of the solar cell is not improved.

The volume average particle diameter of titanium dioxide particles blended with the layer (B) is not less than 0.5 $\mu$m and not more than 2 $\mu$m, and 0.6 $\mu$m to 1.8 $\mu$m is preferable and 0.7 $\mu$m to 1.5 $\mu$m is more preferable. When the volume average particle diameter is less than 0.5 $\mu$m, conversion efficiency of the solar cell is not drastically improved, and when it exceeds 2 $\mu$m, appearance of the layer (B) is deteriorated. Also, the content of particles having a particle diameter of not more than 0.35 $\mu$m in the titanium oxide particles blended with the layer (B) is less than 10 mass%, preferably less than 5 mass%, more preferably less than 3 mass% and particularly preferably less than 2 mass% relative to the whole titanium dioxide particles. When the content of particles having a particle diameter of not more than 0.35 $\mu$m is

not less than 10 mass%, conversion efficiency of the solar cell is not improved.

Meanwhile, the volume average particle diameter and the content of particles of titanium oxide particles in the present invention are calculated based on size distribution of primary particles measured on a transmission electron microscopic photograph with an image analyzer (for example, LUZEX IIIU).

The content of titanium oxide particles is 0.1-40 parts by mass, preferably 0.5-35 parts by mass and more preferably 1-30 parts by mass relative to 100 parts by mass of the thermoplastic resin constituting the respective layers (A) and (B). When the content is less than 0,1 parts by mass, conversion efficiency of the solar cell is not drastically improved, and when it exceeds 40 parts by mass, increase of weight, deterioration of appearance and decrease of mechanical strength occur.

The above layer (C) of the present invention only has to be light transmittable, and can be prepared similarly to the above layers (A) and (B).

The thermoplastic resins constituting the respective layers of the layered product of the present invention may be previously pelletized by blending the required amounts of the respective components, mixing the blend in Henschel mixer or the like, and then melt-kneading it in an extruder, or may be processed into a film or sheet by directly supplying the respective components to a film molding machine or extruding machine. In this instance, antioxidants, ultraviolet absorbents, weather resistant agents, anti-aging agents, fillers, antistatic agents, flame retardants, antifogging agents, slipping agents, antibacterial agents, fungicides, tackifiers, plasticizers, coloring agents, graphite, carbon black, carbon nanotube, and pigments (including a pigment to which functionality such as an infrared absorbing or reflecting property is imparted) can be added to the thermoplastic resin, in an amount which does not impair the object of the present invention.

The layered product of the present invention is a light reflective white layered product, and has a reflectance of a light with a wavelength of 400-1400 nm of preferably not less than 50%. The layered product has a reflectance of a light with a wavelength of 400-1400 nm of preferably not less than 60% and particularly preferably not less than 70%. In the present invention, the reflectance of a light with a wavelength of 400-1400 nm of not less than 50% means that a maximum value of reflectance within a wavelength of 400-1400 nm is not less than 50%, Therefore, it does not require that the reflectance of the entire light within the wavelength or 400-1400 nm is 50% or more. Normally, when the reflectance of a light at one wavelength of the wavelength range of 400-1400 nm is not less than 50%, it is considered that the reflectance of a light with a wavelength adjacent to it is also enhanced to the same extent.

Further, in the present invention, the reflectance of the light within not less than 30% of the wavelength range of 400-1400 nm is preferably not less than 50% and the reflectance of the light within not less than 50% of the wavelength range of 400-1400 nm is more preferably not less than 50%. As the wavelength range in which the reflectance of light is not less than 50% becomes broader within 400-1400 nm, conversion efficiency of the solar cell is further improved when the present product is used as a back sheet for the solar cells.

The layered product of the present invention has an L value (brightness) of preferably not less than 55, more preferably not less than 70, further more preferably not less than 80 and particularly preferably not less than 95 when it is assembled as a layered product.

The layered product of the present invention may be in a form of either sheet or film. For example, when the layered product of the present invention is a film, it can be produced by methods which can be utilized for producing a film of a thermoplastic resin, including, for example, solution cast method, melt extrusion method, coextrusion method and melt press method. The melt extrusion method is excellent for a large scale production, but the solution cast method and melt press method are also useful for the purpose of a small scale or special application or quality evaluation. In the melt extrusion method, T-die or inflation method is used. In the melt press method, calendar method is used. When the layered product of the present invention is a sheet, it can be produced by methods which can be utilized for producing a thermoplastic sheet, including, for example, coextrusion method.

T-die method has an advantage of high-speed production, and in that case, the temperature of resin during molding only has to be not less than the melting temperature and lower than the decomposition temperature of the resin, and generally an appropriate temperature is 150-250°C.

Specifications and molding conditions of molding machine for the inflation method are not limited, and conventionally known methods and conditions can be used. For example, the extruder has a caliber of 10-600 mm in diameter and a ratio L/D of 8-45 wherein D is the caliber, and L is a length from the bottom of the hopper to the tip of cylinder. The die has a shape generally used for inflation molding, for example, has a flow geometry of a spider type, spiral type or stacking type, and has a caliber of 1-5000 mm.

As the molding machine for calendar method, for example, any of tandem-type, L-type, reversed-L-type and Z-type can be used.

Further, the layered product of the present invention can be molded, for example, by making a single-layer film by T-die or inflation molding and then subjecting it to heat or extrusion lamination, but from the viewpoint of production cost, a multi-layer T-die extruder is preferably used for molding.

In the layered product of the present invention, a total thickness of the resin layer (A) and the resin layer (B) is preferably 30-500 $\mu$m, more preferably 70-450 $\mu$m, and further more preferably 80-400 $\mu$m. When the thickness is less than 30 µm, the strength of the layered product may be lowered, and on the other hand, when the thickness exceeds 500 µm, flexibility of the layered product is deteriorated, or weight of the layered product may be .increased.

When the layered product of the present invention has the layer (C), a thickness of the layer (C) is preferably 10-300 µm and more preferably 30-250 µm.

In addition, the layered product of the present invention can be optionally provided on the outer surface thereof with a protective layer (D). Particularly, when the layered product of the present invention is used as a back sheet for solar cells, the protective layer (D) is preferably provided on the outer surface of the layer (C) which is positioned at a side opposite to the solar cell from the viewpoint of conversion efficiency and adhesion to the solar cell.

The protective layer (D) is frequently used in cover films and back sheets for solar cells for improving physical properties such as scratch resistance and penetration resistance, chemical properties such as chemical resistance or thermal properties such as flame resistance, and, in the present invention, is preferably one which can improve flame resistance and scratch resistance of back sheets for solar cells.

Such a protective layer (D) which can be used, includes, for example, fluorocarbon resin films such as polyvinylfluoride film and ethylene-tetrafluoroethylene copolymer film, polycarbonate film, polyarylate film, polyethersulfone film, polysulfone film, polyacrylonitrile film, polyethylene terephthalate (PET) film with hydrolytic resistance, polyethylene naphthalate (PEN) film with hydrolytic resistance, cellulose acetate film, acrylic resin film and polypropylene film with weatherability. Of these, as the protective layer used in the present invention, fluorocarbon resin film, polyethylene terephthalate film with hydrolytic resistance and polyethylene naphthalate film with hydrolytic resistance are preferable due to excellent flame resistance and scratch resistance. These can be used as a single film or a laminated film with two or more layers.

The thickness of the protective layer (D) is preferably 25-300 µm and more preferably 25-200 µm. When the thickness of the protective layer (D) is less than 25µ m, the effect of protecting the layered product is insufficient. When the thickness of the protective layer (D) exceeds 300 µm, flexibility of the layered product is insufficient, and also the weight of the layered product is increased, and thus this is not preferable.

Further, in the layered product of the present invention, the layer (A) or the layer (B) is usually used as a surface (light receiving side) for receiving a light such as sunlight, and thus it can be provided with a pressure sensitive adhesive layer or adhesive layer on a side as the back in order to obtain a cohesive film, adhesive film, cohesive sheet or adhesive sheet. A protective layer can be further provided on a surface of a cohesive layer or adhesive layer so as to protect these layers.

The layered product of the present invention is suitably used as a back sheet for solar cells, especially a back sheet for solar cells of crystalline silicon type, as well as others including interior materials for automobiles, building materials, and colored reflective plates for infrared heaters.

A solar cell module using the back sheet for solar cells of the present invention is usually composed of a transparent substrate such as glass, a sealing film, a solar cell element, a sealing film and the back sheet for solar cells comprising the layered product of the present invention in this order from the sunlight receiving surface side.

As the transparent substrate, generally glass is used. Since glass is excellent in transparency and weatherability but low in impact resistance and heavy, a transparent resin with weatherability is also preferable used for the solar cells placed on the roof of ordinary houses. The transparent resin includes a fluorocarbon resin film. The thickness of the transparent substrate is usually 3-5 mm when glass is used, and usually 0.2-0.6 mm when a transparent resin is used.

As the sealing film, an olefin resin is used. Here, the olefin resin collectively refers to polymers resulting from polymerization or copolymerization of an olefin such as ethylene, propylene, butadiene and isoprene or a diolefin, and includes copolymers of ethylene with another monomer such as vinyl acetate and acrylic acid esters and ionomers thereof. Concretely, it includes polyethylene, polypropylene, polymethylpentene, ethylene/vinyl chloride copolymer, ethylene/vinylacetate copolymer (EVA), ethylene/Vinyl alcohol copolymer, chlorinated polyethylene and chlorinated polypropylene, and of these, EVA is widely used. EVA may be coated as a cohesive agent or adhesive agent or used in a sheet form, but generally is used in a sheet form which is heat-pressed. When it is used in a sheet form, the thickness thereof is usually 0.2-5.0 mm.

As the solar cell element, a known silicon can be used. The silicon may be amorphous silicon, monocrystalline silicon or polycrystalline silicon. Comparing the response bandwidth of solar spectrum between amorphous silicon and polycrystalline silicon, the response bandwidth of amorphous silicon is located on a visible light side, while the response bandwidth of polycrystalline silicone is located on an infrared side. Energy distribution of sunlight is about 3% in ultraviolet region, about 47% in visible light region, and about 50% in infrared region. The use of the back sheet for solar cells of the present invention excellent in reflective property in combination with the solar cell element makes it possible to obtain the solar cell module excellent in conversion efficiency, and also excellent in heat resistance, weather-ability, hydrolytic resistance and flexibility.

The above components of the solar cell module May be bonded together using an adhesive agent. As the adhesive agent, known adhesive agents can be used, including, for example, butyl rubber adhesive agents, silicone adhesive agents and EPDM adhesive agents.

EXAMPLES

Hereinafter, the present invention will be described in more detail by way of Examples. However, the present invention is in no way restricted to the following Examples. The units "parts" and "%" in Examples and Comparative Examples are on mass basis unless otherwise specified.

1. Evaluation method

The measurement methods for various evaluation items in the following Examples and Comparative Examples are shown below.

1-1. Rubber content of thermoplastic resins

It was calculated from a composition of raw materials.

1-2, Glass transition temperature (Tg)

It was measured using differential scanning calorimeter of type DSC2910 (trade name; manufactured by TA Instruments) in accordance with JIS K 7121.

1-3. Improvement rate of conversion efficiency (96% of opening ratio of back sheet)

In a chamber which was conditioned at a temperature of 25°C$\pm$2°C and humidity of 50$\pm$5%RH, conversion efficiency of the solar cell module (0% of opening ratio of back sheet) obtained in Examples and Comparative Examples was measured using a solar simulator PEC-11 manufactured by Peccell. Also, conversion efficiency of the solar cell module (96% of opening ratio of back sheet) obtained examples and Comparative Examples was measured in the same manner. Meanwhile, in order to lower the effect of temperature, conversion efficiency was measured immediately after irradiation with light. Improvement rate of conversion efficiency was determined by the next equation. The higher the improvement rate of the above conversion efficiency is, the higher the conversion efficiency of solar cells is. In addition, the opening ratio of back sheet is a value (B/A) obtained by dividing the area (B) of the surface of the solar cell back sheet which is not covered with the solar cells by the area (A) of the surface of the solar cell back sheet which is covered with the solar cells in the solar cell module.
$$\text{Improvement rate of CE (\%)} = \frac{\text{CE of module with 96\% of back sheet opening ratio} - \text{CE of module with 0\% of back sheet opening ratio}}{\text{CE of module with 0\% of back sheet opening ratio}}$$

in which CE means conversion efficiency.

1-4 Improvement rate of conversion efficiency (32% of opening ratio of back sheet)

In a chamber which was conditioned at a temperature of 25°C$\pm$2°C and humidity of 50$\pm$5%RH, conversion efficiency of the solar cell module (0% of opening ratio of back sheet) obtained in Examples and Comparative Examples was measured using a solar simulator PEC-11 manufactured by Peccell. Also, conversion efficiency of the solar cell module (32% of opening ratio of back sheet) obtained in Examples and Comparative Examples was measured in the same manner. Meanwhile, in order to lower the effect of temperature, conversion efficiency was measured immediately after irradiation with light. Improvement rate of conversion efficiency was determined by the next equation. The higher the improvement rate of the above conversion efficiency is, the higher the conversion efficiency of solar cells is. In addition, the opening ratio of back sheet is a value (B/A) obtained by dividing the area (B) of the surface of the solar cell back sheet which is not covered with the solar cells by the area (A) of the surface of the solar cell back sheet which is covered with the solar cells in the solar cell module.
$$\text{Improvement rate of CE (\%)} =$$

$$\frac{\text{CE of module with 32\% of back sheet opening ratio} - \text{CE of module with 0\% of back sheet opening ratio}}{\text{CE of module with 0\% of back sheet opening ratio}}$$

in which CE means conversion efficiency.

2. Method for producing the layered product

2-1. Raw materials to be used (thermoplastic resin)

2-1-1. Silicone/acrylic composite rubber-reinforced styrene resin

"METABLEN SX-006 (trade name)" manufactured by MITSUBISHI RAYON CO, LTD (a resin modifier which, is an acrylonitrile-styrene copolymer grafted onto a silicone/acrylic composite rubber with a rubber content of 50%, a graft ratio of 80%, a limiting viscosity [η] (at 30°c in methyl ethyl ketone) of 0.38 dl/g and a glass transition temperature (Tg) of 135°C) was used.

2-1-2. Styrene-acrylonitrile copolymer

SAN-H (trade name)" manufactured by Techno Polymer Co., Ltd. (AS resin).

2-1-3. N-phenylmaleimide-acrylonitrile-styrene copolymer

"POLYMILEX PAS1460 (trade name)" manufactured by NIPPON SHOKUBAI CO., LTD. (N-phenylmaleimide-acrylonitrile-styrene copolymer with an N-phenylmaleimide content of 40%)

2-1-4. Ethylene-vinyl acetate copolymer

"NOVATEC EVA LV430 (trade name)" manufactured by Japan Polyethylene Corporation was used. It had a vinyl acetate content of 15% and a melting point of 89°C (DSC).

2-1-5. Polyethylene terephthalate

"NOVAPEX GM700 (trade name)" manufactured by Mitsubishi Chemical Corporation was used. It had a melting point of 255°C (DSC).

2-1-6. Polyethylene

"NOVATEC LL UF641 (trade name)" manufactured by Japan Polyethylene Corporation was used. It had a melting point of 124°C (DSC).

2-2. Raw material to be used (titanium oxide)

2-2-1. Small particle diameter type (1)

"TIPAQUE CR-60-2 (trade name)" (rutile type) manufactured by ISHIHARA SANGYO KAISHA, LTD, with a volume average particle diameter of 0.21 μm, and less than 1 mass% of the content of the particles having a particle diameter of not less than 0.5 μm.

2-2-2, Small particle diameter type (2)

"TIPAQUE CR-58-2 (trade name)" (rutile type) manufactured by ISHIHARA SANGYO KAISHA, LTD., with a volume average particle diameter of 0.28 μm, and less than 1 mass% of the content of the particles having a particle diameter of not less than 0.5 μm,

2-2-3. Large particle diameter type

"JR-1000 (trade name)" manufactured by TAYCA Corporation (rutile type, with a volume average particle diameter of 1.0 μm, and less than 1 mass% of the content of the particles having a particle diameter of not more than 0.35 μm).

2-3. Molding materials for the resin layers (A) and (B)

The components shown in Table 1 were mixed together in Henschel mixer in a. proportion shown in Table 1, and then melt-kneaded using a double-screw extruder (TEX44 manufactured by The Japan Steel Works, LTD.) with a barrel temperature setting at 150-270°C in accordance with a thermoplastic resin to be used to obtain pellets. The resulting composition was evaluated in accordance with the above evaluation methods. The results are shown in Table 1. Meanwhile, since ASA-8 in Table 1 contained a large amount of titanium oxide, it was unable to be used for producing a layered product.

Table 1

| | | | ASA-1 | ASA-2 | ASA-3 | ASA-4 | ASA-6 | ASA-7 | ASA-8 | EVA-1 | PET-1 | PET-2 | PE-1 | PE-2 |
|---|---|---|---|---|---|---|---|---|---|---|---|---|---|---|
| Thermoplastic resin | Silicon/acryl composite rubber-reinforced styrene resin | (part) | 30 | 30 | 30 | 30 | 30 | 30 | 30 | - | - | - | - | - |
| | Syrene-acrylonitrile copolymer | | 30 | 8 | 30 | 8 | 30 | 30 | 30 | - | - | - | - | - |
| | N-phenyimaleimide-acrylonitrile-styrene copolymer | | 40 | 62 | 40 | 62 | 40 | 40 | 40 | - | - | - | - | - |
| | Ethyiene-vinyl acetate copolymer | | - | - | - | - | - | - | - | 100 | - | - | - | - |
| | Polyethylene tereplithalate | | - | - | - | - | - | - | | - | - 100 | 100 | - | - |
| | Polyethylene | | - | - | - | - | | - | | - | - | - | 100 | 100 |
| Titanium oxide | Small particle diameter (1) (D=0.21 $\mu$m) | | 10 | 10 | - | - | - | - | 50 | - | - | 10 | - | 10 |
| | Small particle diameter (2) (D=0.28 $\mu$m) | | - | - | - | - | 10 | - | - | - | - | - | - | - |
| | Large particle diameter (D=1 $\mu$m) | | - | - | 10 | 10 | - | - | - | 10 | 10 | - | 10 | - |
| Glass transition temperature of thermoplastic resin | | (°C) | 135 | 155 | 135 | 155 | 135 | 135 | 135 | - | - | - | - | - |
| Rubber content of thermoplastic resin | | (%) | 15 | 15 | 15 | 15 | 15 | 15 | 15 | - | - | - | - | - |
| Content of N-phenylmaleimide unit in thermoplastic resin | | (%) | 16 | 24.8 | 16 | 24.8 | 16 | 16 | 16 | - | - | - | - | - |

3-1. Production of the solar cell module (Examples 1-5 and Comparative Examples 1-4)

First, the film of each layer was produced by the following method.

A film molding machine equipped with T-die (die width; 1400 mm, lip distance; 0.5 mm) and an extruder with a screw diameter of 65 mm was provided, and a resin was ejected at a melting temperature of 270°C from the T-die to produce a soft film. Then, the soft film was brought into surface-to-surface contact with a cast roll (roll surface temperature; 95°C) by air knife, and cooled and solidified to obtain a film. In this instance, by adjusting operation conditions of the extruders and cast roll, a film with the thickness of 60 μm was obtained.

Meanwhile, the thickness of the film was measured by cutting out a film one hour after the initiation of production of the film, and measuring a thickness at the center and each site at an interval of 10 mm from the center to both terminals in the transverse direction of the film using a thickness gage (type "ID-Cl112C" manufactured by Mitutoyo Corporation), and was taken as an average value thereof. Values measured at sites within a range of 20 mm from the film terminals were omitted from the calculation of the above average value.

Next, the solar cell module was produced by the following method,

Two EVA films ("ULTRAPEAL-PV" (trade nane) manufactured by SUNVIC Inc, dimension: thickness 0.44 mm, 90 mm X 90 mm) were prepared respectively as a back face side sealing film (ii-1) and a front face side sealing film. (ii-2), and also a layered product (i) of the present invention in which the respective film layers (dimension: thickness 60 μm, 90 mm X 90 mm) were layered, polycrystalline solar cells (iii) and a glass substrate (dimension: thickness 3.2 mm, 90 mm X 90 mm) (iv) were prepared, and they were layered in this order: (i)/(ii-1)/(iii)/(ii)/(iv), and then sealed to produce a solar cell module. The opening ratio of the back sheet was adjusted by properly changing the position of the solar cells (iii).

Meanwhile, the sealing was performed with a vacuum laminator of two-door open type provided with an upper chamber and a lower chamber, where the upper and lower chambers were pre-heated at about 150°C for 5 minutes under vacuum, and then the upper chamber was returned to ordinary pressure until the solar cell module was heat-pressed for 15 minute under atmospheric pressure.

The evaluation results of the obtained solar cell module were shown in Table 2.

3-2. Production of the solar cell module (Examples 6-10, Comparative Examples 5-8)

The solar cell module was produced and evaluated in the same manner as above in 3-1 except that a monocrystalline solar cell was used instead of the polycrystalline solar cell.

The evaluation results of the obtained solar cell module were shown in Tables 3-6.

Table 2

| | | Example | | | | | Comparative Example | | | |
|---|---|---|---|---|---|---|---|---|---|---|
| | | 1 | 2 | 3 | 4 | 5 | 1 | 2 | 3 | 4 |
| layer constitution | First layer | ASA-1 | ASA-2 | ASA-1 | ASA-3 | ASA-6 | ASA-1 | ASA-3 | ASA-6 | ASA-7 |
| | Second layer | ASA-3 | ASA-4 | ASA-4 | ASA-1 | ASA-3 | ASA-1 | ASA-3 | ASA-1 | ASA-7 |
| | Third layer | - | - | ASA-1 | - | - | - | - | - | - |
| Improvement rate of conversion efficiency(%) (96% back sheet opening ratio) | | 12.7 | 12.7 | 12.7 | 12.8 | 12.7 | 10.9 | 11.4 | 10.7 | 7,0 |

Table 3

| | | Example | | Comparative Example |
|---|---|---|---|---|
| | | 6 | 7 | 5 |
| Lawyer constitution | First layer | ASA-3 | ASA-1 | ASA-3 |
| | Second layer | ASA-1 | ASA-3 | ASA-3 |
| improvement rate of conversion efficiency (32% back sheet opening ratio) | | 6.05 | 7.17 | 5.62 |

Table 4

| | | Example | Comparative Example |
|---|---|---|---|
| | | 8 | 6 |
| Layer constitution | First layer | ASA-1 | ASA-3 |
| | Second layer | EVA-1 | EVA-1 |
| improvement rate of conversion efficiency (32% back sheet opening ratio) | | 6.16 | 5.79 |

Table 5

| | | Example | Comparative Example |
|---|---|---|---|
| | | 9 | 7 |
| Layer constitution | Firtst layer | PET-1 | PET-2 |
| | Second layer | PET-2 | PET-2 |
| improvement rate of conversion efficiency (32% back sheet opening ratio) | | 6.96 | 5.72 |

Table 6

| | | Example | Comparative Example |
|---|---|---|---|
| | | 10 | 8 |
| Layer constitution | First layer | PE-1 | PE-2 |
| | Second layer | PE-2 | PE-2 |
| improvement rate of conversion efficiency (32% back sheet opening ratio) | | 7.02 | 5.76 |

From the results of Tables 2-6, it was found that conversion, efficiency of solar cells was improved using the layered products of Examples 1-10 having the layers (A) and (B) of the present invention than the layered products of Comparative Examples 1-8 having neither or either of the layers (A) and (B). Meanwhile, the layered product of Example 3 was excellent particularly in balance between heat resistance and flexibility.

INDUSTRIAL APPLICABILITY

The layered product of the present invention is excellent in sunlight reflective property, and thus can be used as back sheets for solar cells, and also can be used as infrared reflective materials and materials with low heat storage.

**Claims**

1. A layered product having a layer (A) and a layer (B), in which said layer (A) is formed of a thermoplastic resin composition comprising 0.1-40 parts by mass of titanium oxide particles per 100 parts by mass of a thermoplastic resin in which the titanium oxide particles have a volume average particle diameter of not less than 0.01 $\mu$m and not more than 0.35 $\mu$m and contain less than 10 mass% of particles of not less than 0.5 $\mu$m in particle diameter relative to the whole particles, and said layer (B) is formed of a thermoplastic resin composition comprising 0.1-40 parts by mass of titanium oxide particles per 100 parts by mass of a thermoplastic resin in which the titanium oxide particles have a volume average particle diameter of not less than 0.5 $\mu$m and not more than 2 $\mu$m and contain less than 10 mass% of particles of not more than 0.35 $\mu$m in particle diameter relative to the whole particles.

2. The layered product according to claim 1, wherein the titanium oxide is a rutile type.

3. The layered product according to claim 1 or 2, wherein said thermoplastic resin of the above layer (A) and/or said thermoplastic resin of the above layer (B) comprise an aromatic vinyl resin (1), a polyester resin (II) or a polyolefin resin (III).

4. The layered product according to claim 3, wherein said thermoplastic resin of the above layer (A) and/or said thermoplastic resin of the above layer (B) comprise an aromatic vinyl resin (I) comprising a rubber-reinforced aromatic vinyl resin (I-1) obtained by polymerization of a monomer (b) comprising an aromatic vinyl compound in a presence of a rubbery polymer (a) and optionally a (co)polymer (I-2) of a monomer (b) comprising an aromatic vinyl compound, the content of the rubbery polymer (a) being 5-40 parts by mass relative to 100 parts by mass of the aromatic vinyl resin (I),

5. The layered product according to claim 4, wherein said rubbery polymer (a) is at least one selected from the group consisting of ethylene-$\alpha$-olefin rubbers ($\alpha$-1), hydrogenated conjugated diene rubbers (a-2), acrylic rubbers (a-3), silicone rubbers (a-4) and silicone/acrylic composite rubbers (a-5) .

6. The layered product according to claim 1, wherein the above layer (A) is layered directly on the above layer (B).

7. The layered product according to claim 1, wherein the above layer (A) is layered on the above layer (B) via another layer (C).

8. The layered product according to claim 6 or 7, wherein the above layer (A) is directly layered or layered via another layer (C) on both sides of the above layer (B).

9. The layered product according to claim 6 or 7, wherein the above layer (B) is directly layered or layered via another layer (C) on both sides of the above layer (A).

10. A back sheet for solar cells, which comprises the layered product according to any one of claims 1 to 9.

11. A solar cell module, which comprises the back sheet for solar cells according to claim 10.

## INTERNATIONAL SEARCH REPORT

| | International application No. |
|---|---|
| | PCT/JP2010/051272 |

**A. CLASSIFICATION OF SUBJECT MATTER**
*B32B27/20*(2006.01)i, *H01L31/042*(2006.01)i

According to International Patent Classification (IPC) or to both national classification and IPC

**B. FIELDS SEARCHED**

Minimum documentation searched (classification system followed by classification symbols)
B32B1/00-43/00, H01L31/042

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2008-036823 A (Teijin DuPont Films Japan Ltd.),<br>21 February 2008 (21.02.2008),<br>claims; paragraphs [0001], [0017], [0019], [0024], [0025], [0030], [0053]; example 10<br>(Family: none) | 1-3,6-11<br>1-11 |
| Y | JP 2009-012454 A (Toray Industries, Inc.),<br>22 January 2009 (22.01.2009),<br>claims; paragraphs [0017], [0018]<br>& US 2008/0311385 A1 | 1-11 |
| Y | JP 2007-129204 A (Toray Industries, Inc.),<br>24 May 2007 (24.05.2007),<br>claims; paragraphs [0030], [0033], [0050]<br>(Family: none) | 1-11 |

| ☒ Further documents are listed in the continuation of Box C. | ☐ See patent family annex. |
|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>19 March, 2010 (19.03.10) | Date of mailing of the international search report<br>30 March, 2010 (30.03.10) |
|---|---|
| Name and mailing address of the ISA/<br>Japanese Patent Office | Authorized officer |
| Facsimile No. | Telephone No. |

Form PCT/ISA/210 (second sheet) (July 2009)

20

**INTERNATIONAL SEARCH REPORT**

International application No.

PCT/JP2010/051272

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2008-068482 A  (Teijin Fibers Ltd.),<br>27 March 2008 (27.03.2008),<br>paragraph [0011]<br>(Family: none) | 1-11 |
| Y | JP 2007-103813 A  (Techno Polymer Co., Ltd.),<br>19 April 2007 (19.04.2007),<br>paragraphs [0011] to [0013]<br>(Family: none) | 4,5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006270025 A
- JP 2007177136 A
- US 2891920 A
- US 3294725 A
- JP H04239010 A
- JP 2137934 B